# EUROPEAN PATENT SPECIFICATION

(11) **EP 0 588 131 B1**
(45) Date of publication and mention of the grant of the patent: **06.12.2000**
(21) Application number: 93113771.5
(22) Date of filing: 27.08.1993
(51) Int. Cl.: H03M 1/08, H03M 1/00

(54) **Sensor voltage reading circuit**
Sensorspannungsleseschaltung
Circuit de lecture de tension de capteur

(30) Priority: 17.09.1992 JP 24781792
(43) Date of publication of application: 23.03.1994
(73) Proprietor: HONDA GIKEN KOGYO KABUSHIKI KAISHA, Minato-ku Tokyo (JP)
(72) Inventor: Honda, Satoshi, c/o K.K. Honda Gijutsu, Wako-shi, Saitama (JP); Nakazawa, Yoshihiro, c/o K.K. Honda Gijutsu, Wako-shi, Saitama (JP)
(74) Representative: Huber, Bernhard, Dipl.-Chem.

(56) References cited:
- EP-A- 0 455 311
- US-A- 4 135 381
- US-A- 4 713 347
- US-A- 4 719 512
- US-A- 4 743 762

## Description

The present invention relates to a sensor voltage reading circuit for reading an output voltage of a sensor (an analog value outputting sensor) for outputting an analog value, said output voltage being in accordance with said analog value.

From US 4,743,762, a sensor charge packet reading circuit for reading an output charge packet of a sensor, namely an infrared detector, is known. The charge packet outputted by the sensor represents the IR radiation to which the detector was exposed during a time interval (frame interval). The sensor charge packet reading circuit comprises a first capacitor and a second capacitor and coupling means for selectively conductively coupling the two capacitors. Further, resetting means for resetting the first capacitor and the second capacitor to a predetermined voltage potential are provided. The measurement technique disclosed in the U.S. patent document using the sensor charge packet reading circuit comprises the steps: resetting the first capacitor and the second capacitor to a predetermined voltage potential; conductively uncoupling the first capacitor from the second capacitor; integrating on the first capacitor for a predetermined interval of time the charge received from the IR detector to produce a detector signal voltage potential across the first capacitor representing the received charge; determining the magnitude of a quiescent voltage potential across the second capacitor, the quiescent voltage potential being a function of the predetermined voltage level; conductively coupling together the first and the second capacitors; equilibrating the detector signal voltage potential and the quiescent voltage potential to obtain a difference voltage potential; and determining the magnitude of the difference voltage potential, the magnitude of the difference potential being a function of the amount of IR radiation incident upon the radiation detector during the predetermined interval of time.

The voltage potential across the first capacitor increases over the measurement time interval and the produced detector signal voltage potential is the voltage potential across the first capacitor at the end of the measurement interval, namely at time S₃. The voltage potential across the second capacitor remains constant over the measurement time interval and corresponds to the reset voltage potential of the first capacitor before the beginning of the measurement interval, namely at time S₁. Accordingly, the difference voltage potential is derived by forming the difference between two voltage potentials associated with two different points in time, namely with S₃ and S₁. By the subtraction of the two voltage potentials noise common to both voltage potentials, namely noise not changing over the measuring time interval, is cancelled.

From U.S. 4,135,381 an impedance measuring circuit is known measuring the internal impedance of a sensor. The sensor is connected over a capacitor with a reference impedance, so that the sensor internal impedance and the reference impedance form a voltage divider. The voltage divider is connected on the sensor side with ground and on the reference impedance side with a square wave generator. The internal impedance of the sensor, which changes with temperature, determines the voltage division value of the voltage divider, which accordingly is also dependent on the temperature of the sensor. A voltage at a junction between the reference impedance and the sensor internal impedance, which is determined by the momentary divisional value, represents the sensor internal impedance and, accordingly, the temperature of the sensor.

Further, a sensor voltage reading circuit is provided which is directly connected with the sensor, namely with a junction between the sensor and the capacitor separating the sensor and the reference impedance. The sensor voltage reading circuit is not affected by the measurement arrangement for measuring the sensor temperature via the sensor internal impedance.

It is an object of the present invention to provide such a sensor voltage reading circuit which is adapted to remove noise voltages caused by electric noise superimposed on the electric signal relating to the output voltage, in particular to remove time-dependent electromagnetic wave noise such as noise voltages caused by radio waves which are mixed into a respective input terminal leading to an analog/digital conversion circuit.

To achieve this object, a sensor voltage reading circuit is provided having the features of claim 1.

Since a plurality of voltage divisional circuits is provided, the input voltage to the sensor voltage reading circuit can be simultaneously divided according to a plurality of different voltage division values, which can be converted by the analog/digital conversion circuit into a corresponding plurality of digital values. To this end, the divisional voltages are inputted to said analog/digital conversion circuit individually by way of input terminals of said analog/digital conversion circuit. Discrimination means are provided for discriminating said divisional voltages, so that the output voltage can be read with higher accuracy. In particular, the discrimination means can comprise a noise voltage removal circuit for removing electric noise of equal value inputted individually from the input terminals of said analog/digital conversion circuit. The removal of noise can be effected by calculating the difference between a first digital value representing a first divisional voltage and a second digital value representing a second divisional voltage.

In the sensor voltage reading circuit according to the present invention, the output voltage of an analog value outputted from the sensor is inputted to the analog/digital conversion circuit by way of the plurality of voltage division circuits having different voltage division values. Based on the individual digital values obtained by conversion of the analog/digital conversion circuit, a noise voltage removal circuit may remove electromagnetic wave noises of an equal value inputted to the respective input terminals of the analog/digital conversion circuit from the respective digital values obtained by the conversion.

Consequently, an output voltage of the sensor from which the electromagnetic wave noises inputted to the input terminals of the analog/digital conversion circuits have been removed can be obtained.

In the sensor voltage reading circuit according to the present invention, a voltage change-over means energized by the control means may supply a voltage to the power source terminal of the sensor. Then, the control means energizes the sensor output reading means for reading the output voltage of the sensor.

Accordingly, a voltage is applied to the power source terminal of the sensor only when the output voltage of the sensor is to be read.

In the following, preferred embodiments of a sensor voltage reading circuit according to the present invention will be given and described in detail with reference to the accompanying drawings.
FIG. 1 is a view showing a sensor voltage reading circuit embodying the present invention.
FIG. 2 is a view showing another sensor voltage reading circuit embodying the present invention.

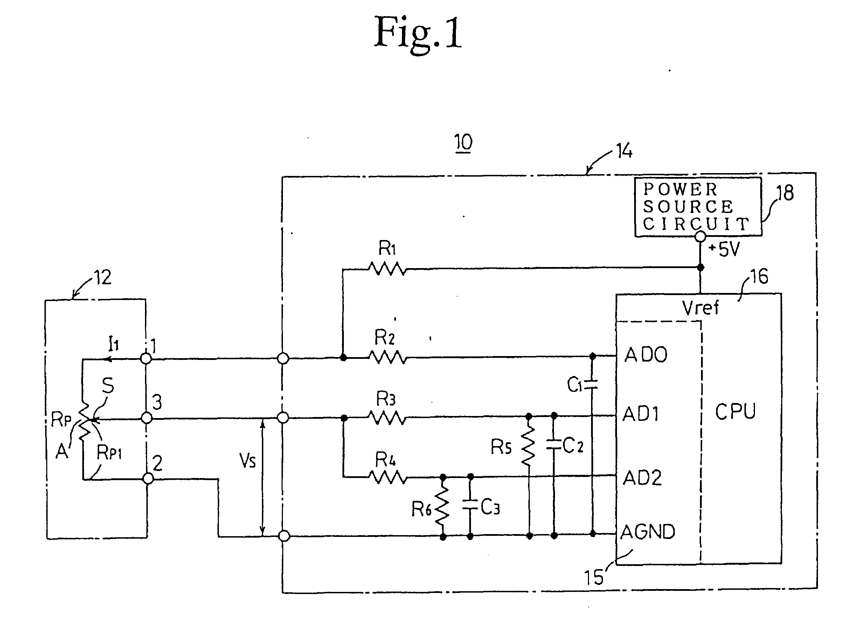

FIG. 1 is a view showing a construction of a sensor voltage reading apparatus 10 embodying the present invention.

Referring to FIG. 1, reference numeral 12 denotes a potentiometer of the contact type as an analog sensor which outputs a voltage in accordance with an amount of rotation, and reference numeral 14 denotes a sensor voltage reading circuit.

The potentiometer 12 includes a resistor R_{P}, a sliding element S which slidably moves on the resistor R_{P}, and a shaft not shown for driving the sliding element S to rotate, and the potentiometer 12 further includes a terminal 1 connected to an end portion of the resistor R_{P}, another terminal 2 connected to the other end portion of the resistor R_{P}, and a further terminal 3 connected to the sliding element S.

The sensor voltage reading circuit 14 includes a CPU 16 provided with an A/D conversion circuit 15, and a power source circuit 18 for supplying dc power as power to a terminal V_{ref} of the CPU 16 and supplying the dc power to the terminal 1 of the potentiometer 12 by way of a resistor R₁.

The terminal 1 of the potentiometer 12 is connected to a terminal of a resistor R₂, and the other terminal of the resistor R₂ is connected to an input terminal AD0 of the A/D conversion circuit 15 and also connected to a terminal of a capacitor C₁ for absorbing noise superimposed on the power. The other terminal of the capacitor C₁ is connected to an analog ground (hereinafter referred to as AGND) terminal of the A/D conversion circuit 15, and the terminal 2 of the potentiometer 12 is connected to the AGND terminal of the A/D conversion circuit 15.

The terminal 3 of the potentiometer 12 is connected to a terminal of a resistor R₃ and connected also to a terminal of another resistor R₄, and the other terminal of the resistor R₃ is connected to a first input terminal AD1 of the A/D conversion circuit 15, a terminal of a resistor R₅ and a terminal of a capacitor C₂. The other terminal of the resistor R₆ and the other terminal of the capacitor C₂ are connected to the AGND terminal of the A/D conversion circuit 15.

Accordingly, the voltage between the terminal 2 and the terminal 3 of the potentiometer 12 serves as an output voltage V_{S} of the potentiometer 12.

In this instance, the resistor R₃ and the resistor R₅ construct a first voltage division circuit for dividing the output voltage V_{S} of the potentiometer 12, and the resistor R₃ and the capacitor C₂ construct a first low-pass filter LPF for passing a low frequency region of the output voltage V_{S} of the potentiometer 12.

The other terminal of the resistor R4 is connected to a second input terminal AD2 of the A/D conversion circuit 15 and also connected to a terminal of a resistor R₆ and a terminal of a capacitor C₃, and the other terminal of the resistor R₆ and the other terminal of the capacitor C₃ are connected to the AGND terminal of the A/D conversion circuit 15.

The resistor R₄ and the resistor R₆ construct a second voltage division circuit for dividing the output voltage V_{S} of the potentiometer 12, and the resistor R₄ and the capacitor C₃ construct a second low-pass filter LPF for passing a low frequency region of the output voltage Vs of the potentiometer 12.

Action of the sensor voltage reading circuit 14 constructed in such a manner as described above when it reads the output voltage V_{S} of the potentiometer 12 and removes a noise voltage caused by radio waves and mixed in from the input terminal AD1 and the input terminal AD2 of the A/D conversion terminal 15 will be described in detail below.

A voltage is applied from the power source circuit 18 by way of the resistor R₁ to the terminal 1 of the potentiometer 12, and then, the shaft of the potentiometer 12 is driven to rotate from the outside to displace the sliding element S. When the sliding element S is stopped at a point A at which, for example, a resistance value R_{P1} is provided between the terminal 2 and the terminal 3, the output voltage V_{S} at the terminal 3 is given by the following equation:${\text{V}}_{\text{S}} {\text{= I}}_{\text{1}} {\text{x R}}_{\text{P1}}$

In the equation (1) above, I₁ represents a current flowing through the potentiometer 12. The output voltage V_{S} is inputted to the first input terminal AD1 of the A/D conversion circuit 15 by way of the first voltage division circuit constituted from the resistor R₃ and the resistor R₅ and the first low-pass filter LPF and is inputted to the second input terminal AD2 of the A/D conversion circuit 15 by way of the second voltage division circuit constituted from the resistor R₄ and the resistor R₆ and the second low-pass filter LPF.

Accordingly, the input voltage V_{AD1} to be inputted to the input terminal AD1 is given by an equation (2) and the input voltage V_{AD2} to be inputted to the input terminal AD2 is given by an equation (3):$\begin{matrix}\begin{matrix}\begin{matrix}{\text{V}}_{\text{AD1}} {\text{= {R}}_{\text{5}} {\text{/(R}}_{\text{3}} {\text{+ R}}_{\text{6}} {\text{)} x V}}_{\text{S}}\end{matrix} \\ \begin{matrix}{\text{V}}_{\text{AD2}} {\text{= {R}}_{\text{6}} {\text{/(R}}_{\text{4}} {\text{+ R}}_{\text{6}} {\text{)} x V}}_{\text{S}}\end{matrix}\end{matrix}\end{matrix}$

Meanwhile, a noise voltage superimposed on the output voltage V_{S} of the potentiometer 12 is cut off individually by the first low-pass filter LPF and the second low-pass filter LPF.

In this instance, if radio waves are mixed into the input terminal AD1 and the input terminal AD2 and an equal noise voltage Vₙ is produced between the AGND terminal and the input terminal AD1 and between the AGND terminal and the input terminal AD2 by the radio waves, then the input voltage V_{AD1} at the input terminal AD1 given by the equation (2) above is given by an equation (4), and the input voltage V_{AD2} at the input terminal AD2 given by the equation (3) above is given by an equation (5):$\begin{matrix}\begin{matrix}\begin{matrix}{\text{V}}_{\text{AD1}} {\text{= {R}}_{\text{5}} {\text{/(R}}_{\text{3}} {\text{+ R}}_{\text{5}} {\text{)} x V}}_{\text{S}} {\text{+ V}}_{\text{n}}\end{matrix} \\ \begin{matrix}{\text{V}}_{\text{AD2}} {\text{= {R}}_{\text{6}} {\text{/(R}}_{\text{4}} {\text{+ R}}_{\text{6}} {\text{)} x V}}_{\text{S}} {\text{+ V}}_{\text{n}}\end{matrix}\end{matrix}\end{matrix}$

The input voltage V_{AD1} of an analog value obtained from the equation (4) above and the input voltage V_{AD2} of an analog value obtained from the equation (5) above are individually converted into digital values by the A/D conversion circuit 15, and the digital values are read by the CPU 16. The CPU 16 executes calculation for removing the noise voltage Vₙ caused by the radio waves based on the individually read digital values.

In particular, the CPU 16 executes a calculation to find out a difference between the equation (4) and the equation (5).$\begin{matrix}\begin{matrix}\begin{matrix}{\text{V}}_{\text{AD1}} {\text{- V}}_{\text{AD2}} {\text{= [{R}}_{\text{5}} {\text{/(R}}_{\text{3}} {\text{+ R}}_{\text{5}} {\text{)} x V}}_{\text{S}} {\text{+ V}}_{\text{n}} {\text{] - [{R}}_{\text{6}} {\text{/(R}}_{\text{4}} {\text{+ R}}_{\text{6}} {\text{)} x V}}_{\text{S}} {\text{+ V}}_{\text{n}} \text{]}\end{matrix} \\ \begin{matrix}{\text{V}}_{\text{AD1}} {\text{- V}}_{\text{AD2}} {\text{= {R}}_{\text{5}} {\text{/(R}}_{\text{3}} {\text{+ R}}_{\text{5}} {\text{) - R}}_{\text{6}} {\text{/(R}}_{\text{4}} {\text{+ R}}_{\text{6}} {\text{)} x V}}_{\text{S}}\end{matrix}\end{matrix}\end{matrix}$ and the output voltage V_{S} of the potentiometer 12 is calculated from the equation (7) above.${\text{V}}_{\text{S}} {\text{= (V}}_{\text{AD1}} {\text{- V}}_{\text{AD2}} {\text{)/{R}}_{\text{5}} {\text{/(R}}_{\text{3}} {\text{+ R}}_{\text{5}} {\text{) - R}}_{\text{6}} {\text{/(R}}_{\text{4}} {\text{+ R}}_{\text{6}} \text{)}}$

By the calculations described above, the output voltage V_{S} at the displaced point A, to which the sliding element S of the potentiometer 12 has been displaced, from which the equal noise voltage Vₙ mixed to the input terminal AD1 and the input terminal AD2 has been removed, can be obtained.

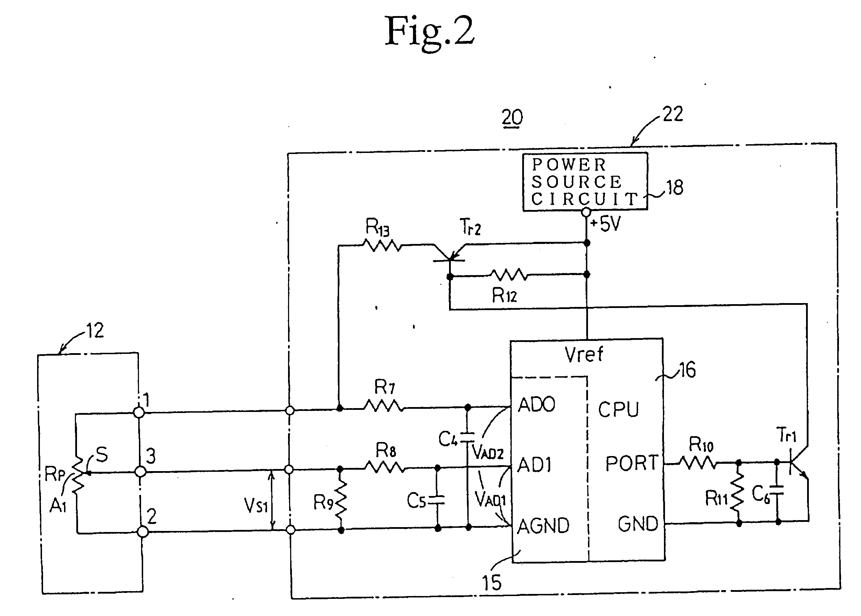

Subsequently, an embodiment of a sensor voltage reading apparatus 20 which suppresses power dissipation of an analog sensor will be described with reference to FIG. 2.

It is to be noted that same components to those of FIG. 1 are denoted by same reference characters and detailed description thereof is omitted herein.

A terminal 1 of a potentiometer 12 is connected to an input terminal AD0 of an A/D conversion circuit 15 by way of a resistor R₇ of a sensor voltage reading circuit 22, and another terminal 2 of the potentiometer 12 is connected to an AGND terminal of the A/D conversion circuit 15 while a further terminal 3 of the potentiometer 12 is connected to an input terminal AD1 of the A/D conversion circuit 15 by way of a resistor R₈.

A capacitor C₄ for absorbing noise is connected between the input terminal AD0 and the AGND terminal of the A/D conversion circuit 15, and another capacitor C₅ is connected between the input terminal AD1 and the AGND terminal of the A/D conversion circuit 15. The resistor R₈ and the capacitor C₅ construct a third low-pass filter LPF.

Further, a resistor R₉ is connected between the terminal 3 and the terminal 2 of the potentiometer 12.

Meanwhile, an output port PORT of the CPU 16 is connected to the base terminal of an NPN-type transistor Tᵣ₁ by way of a resistor R_{10̸}, and a digital ground (hereinafter referred to as DGND) terminal of the CPU 16 and the emitter terminal of the transistor Tᵣ₁ are connected to each other. In this instance, the AGND terminal and the DGND terminal of the A/D conversion circuit 15 are connected to each other in the inside of the A/D conversion circuit 15.

A resistor R₁₁ and a capacitor C₆ are connected in parallel between the base terminal and the emitter terminal of the transistor Tᵣ₁.

The collector terminal of the transistor Tᵣ₁ is connected to the base terminal of a PNP-type transistor Tᵣ₂ as another switching terminal, and the emitter terminal of the transistor Tᵣ₂ is connected to the output terminal of a power source circuit 18. A bias resistor R₁₂ is connected between the base terminal of the transistor Tᵣ₂ and the emitter terminal of the transistor Tᵣ₂, and the collector terminal of the transistor Tᵣ₂ and the terminal 1 of the potentiometer 12 are connected to each other by way of a resistor R₁₃.

Action of reading the output voltage V_{S1} of the potentiometer 12 by means of the sensor voltage reading circuit 22 constructed in such a manner as described above will be described.

If a signal of a "H" level is outputted from the output terminal PORT of the CPU 16, then the collector and the emitter of the transistor Tᵣ₁ as the switching element are put into an "ON" state. Consequently, the emitter and the collector of the transistor Tᵣ₂ are put into an "ON" state so that a voltage is applied to the terminal 1 of the potentiometer 12.

Thus, the A/D conversion circuit 15 energized by the CPU 16 converts the voltage V_{AD1} inputted to the input terminal AD1 of the A/D conversion circuit 15 into a digital value, and the digital value is read by the CPU 16. In this instance, by selecting the values of the resistor R₈ and the resistor R₉ so as to satisfy the relationship R₈ >> R₉, V_{S1} ö V_{AD1} is satisfied.

The output voltage V_{S1} at a displaced position A₁ of the sliding element S of the potentiometer 12, which has been displaced by driving rotation of the shaft, is read in this manner.

In this instance, the CPU 16 reads the voltage V_{AD0̸} inputted to the input terminal AD0, and calculates a percentage of the displaced point A₁ of the sliding element S from the value of the voltage V_{AD0̸} and the output voltage V_{S1} of the potentiometer 12, that is, the voltage V_{AD1} inputted to the input terminal AD1, in accordance with the following equation:${\text{A}}_{\text{1}} {\text{= (V}}_{\text{AD1}} {\text{/V}}_{\text{AD0̸}} \text{) x 100 (%)}$

In this manner, according to the present embodiment, the CPU 16 reads the output voltage V_{S1} of the potentiometer 12 after it outputs to the output port PORT a signal to apply a voltage to the terminal 1 of the potentiometer 12, and when it does not read the output voltage V_{S1} of the potentiometer 12, a voltage is not applied to the terminal 1 of the potentiometer 12, and accordingly, the electric energy dissipated by the potentiometer 12 can be suppressed.

With the sensor voltage reading circuit according to the present invention, since an output voltage of the sensor from which electric noises mixed at the input terminals of the analog/digital conversion circuit have been removed can be obtained, an effect that the reading accuracy of the output voltage of the sensor can be enhanced is exhibited.

Further, since a voltage is applied to the power source terminal of the sensor only when the output voltage of the sensor is to be read but no voltage is applied to the power source terminal of the sensor when the output of the sensor is not to be read, suppression of the power dissipated by the sensor is permitted, and it is possible to achieve minimization of the power source circuit.

Accordingly, an effect that heat generation of the power source circuit can be suppressed and cooling of the entire apparatus in which the power source circuit is accommodated is facilitated is exhibited.

## Claims

1. A sensor voltage reading circuit for reading an output voltage (V_{S}) of a sensor (12) for outputting an analog value, said output voltage (V_{S}) being in accordance with said analog value, characterized in that the sensor voltage reading circuit comprises:
a plurality of voltage division circuits (R₃, R₅; R₄, R₆) receiving said output voltage (V_{S}) as an input voltage (V_{S}) to said sensor voltage reading circuit and having different voltage division values ({R₅/(R₃ + R₅)}, {R₆/(R₄ + R₆)}) to provide a plurality of divisional voltages (${\text{V}}_{\text{AD1}} {\text{= {R}}_{\text{5}} {\text{/(R}}_{\text{3}} {\text{+ R}}_{\text{5}} {\text{)}V}}_{\text{S}}$; ${\text{V}}_{\text{AD2}} {\text{= {R}}_{\text{6}} {\text{/(R}}_{\text{4}} {\text{+ R}}_{\text{6}} {\text{)}V}}_{\text{S}}$), each voltage divisional circuit (R₃, R₄; R₄, R₆) dividing said input voltage (V_{S}) according to the respective voltage divisional value ({R₅/(R₃ + R₅)}; {R₆/(R₄ + R₆)}) to provide a respective divisional voltage (${\text{V}}_{\text{AD1}} {\text{= {R}}_{\text{5}} {\text{/(R}}_{\text{3}} {\text{+ R}}_{\text{5}} {\text{)}V}}_{\text{S}}$; ${\text{V}}_{\text{AD2}} {\text{= {R}}_{\text{6}} {\text{/(R}}_{\text{4}} {\text{+ R}}_{\text{6}} {\text{)}V}}_{\text{S}}$);
an analog/digital conversion circuit (15) for converting the plurality of divisional voltages into digital values; and
discrimination means (16) for discriminating the divisional voltages (V_{AD1}, V_{AD2}) inputted to said analog/digital conversion circuit (15) individually by way of input terminals (AD1, AD2) of said analog/digital conversion circuit (15) as the output voltage (V_{S}) of said sensor (12).

2. A sensor voltage reading circuit according to claim 1, characterized in that said discrimination means (16) are constituted from a noise voltage removal circuit for removing electric noises of an equal value (Vₙ) inputted individually from the input terminals (AD1, AD2) of said analog/digital conversion circuit (15) from the respective digital values obtained by conversion of said analog/digital conversion circuit (15).

3. A sensor voltage reading circuit according to claim 2, characterized in that the noise voltage removal circuit is adapted to calculate the difference between a first divisional voltage (V_{AD1}) and a second divisional voltage (V_{AD2}) and to calculate the output voltage (V_{S}) from this difference.

4. A sensor voltage reading circuit according to one of the preceding claims, characterized by
voltage change-over means (Tr₁, Tr₂) for energizing or deenergizing a supply voltage to be supplied to a power source terminal (1) of said sensor (12); and
control means (16) for energizing said voltage change-over means (Tr₁, Tr₂) to supply the supply voltage to the power source terminal (1) of said sensor (12) and energizing said sensor output reading means (15) to read the output voltage (V_{S1}) of said sensor (12),
wherein the supply voltage is supplied to the power source terminal (1) of the sensor (12) only when the output voltage (V_{S1}) of the sensor (12) is to be read.

## Patentansprüche

1. Sensorspannung-Leseschaltung zum Lesen einer Ausgangsspannung (V_{S}) eines Sensors (12), der einen Analogwert ausgibt, wobei die Ausgangsspannung (V_{S}) dem Analogwert entspricht, dadurch gekennzeichnet, daß die Sensorspannung-Leseschaltung aufweist:
mehrere Spannungsteilerschaltungen (R₃, R₅; R₄, R₆) die die Ausgangsspannung (V_{S}) als Eingangsspannung (V_{S}) für die Sensorspannung-Leseschaltung empfangen und unterschiedliche Spannungsteilungswerte aufweisen ({R₅/(R₃ + R₅)}, {R₆/(R₄ + R₆)}), um mehrere Teilungsspannungen (${\text{V}}_{\text{AD1}} {\text{= {R}}_{\text{5}} {\text{/(R}}_{\text{3}} {\text{+ R}}_{\text{5}} {\text{)}V}}_{\text{S}}$; ${\text{V}}_{\text{AD2}} {\text{= {R}}_{\text{6}} {\text{/(R}}_{\text{4}} {\text{+ R}}_{\text{6}} {\text{)}V}}_{\text{S}}$) zu erzeugen, wobei jede Spannungsteilerschaltung (R₃, R₅; R₄, R₆) die Eingangsspannung (V_{S}) entsprechend dem jeweiligen Spannungsteilungswert ({R₅/(R₃ + R₅)}, {R₆/(R₄ + R₆)}) teilt, um eine entsprechende Teilungsspannung (${\text{V}}_{\text{AD1}} {\text{= {R}}_{\text{5}} {\text{/(R}}_{\text{3}} {\text{+ R}}_{\text{5}} {\text{)}V}}_{\text{S}}$; ${\text{V}}_{\text{AD2}} {\text{= {R}}_{\text{6}} {\text{/(R}}_{\text{4}} {\text{+ R}}_{\text{6}} {\text{)}V}}_{\text{S}}$) zu erhalten;
eine Analog/Digital-Umsetzerschaltung (15) zum Umsetzen der mehreren Teilungsspannungen in digitale Werte; und
eine Diskriminierungseinrichtung (16) zum Diskriminieren der Teilungsspannungen (V_{AD1}, V_{AD2}), die in die Analog/Digital-Umsetzerschaltung (15) individuell über die Eingangsanschlüsse (AD1, AD2) der Analog/Digital-Umsetzerschaltung (15) als die Ausgangsspannung (V_{S}) des Sensors (12) eingegeben werden.

2. Sensorspannung-Leseschaltung nach Anspruch 1, dadurch gekennzeichnet, daß die Diskriminierungseinrichtung (16) gebildet wird von einer Störspannungbeseitigungsschaltung zum Entfernen der elektrischen Störungen eines Gleichtaktwertes (Vₙ), die individuell von den Eingangsanschlüssen (AD1, AD2) der Analog/Digital-Umsetzerschaltung (15) eingegeben werden, von den entsprechenden digitalen Werten, die erhalten werden durch die Umsetzung der Analog/Digital-Umsetzerschaltung (15).

3. Sensorspannung-Leseschaltung nach Anspruch 2, dadurch gekennzeichnet, daß die Störspannungbeseitungsschaltung so beschaffen ist, daß sie die Differenz zwischen einer ersten Teilungsspannung (V_{AD1}) und einer zweiten Teilungsspannung (V_{AD2}) berechnet und die Ausgangsspannung (V_{S}) aus dieser Differenz berechnet.

4. Sensorspannung-Leseschaltung nach einem der vorangehenden Ansprüche, gekennzeichnet durch
eine Spannungswechselschaltung (Tr₁, Tr₂) zum Aktivieren oder Deaktivieren einer Versorgungsspannung, die einem Stromversorgungsanschluß (1) des Sensors (12) zugeführt wird; und
eine Steuereinrichtung (16) zum Aktivieren der Spannungswechseleinrichtung (Tr₁, Tr₂), um die Versorgungsspannung dem Stromversorgungsanschluß (1) des Sensors (12) zuzuführen, und zum Aktivieren der Sensorausgangs-Leseeinrichtung (15), um die Ausgangsspannung (V_{S1}) des Sensors (12) zu lesen; wobei
die Versorgungsspannung dem Stromversorgungsanschluß (1) des Sensors (12) nur dann zugeführt wird, wenn die Ausgangsspannung (V_{S}) des Sensors (12) gelesen werden soll.

## Revendications

1. Un circuit de lecture de tension de capteur, pour lire une tension de sortie (Vₛ) d'un capteur (12) devant fournir une valeur analogique, ladite tension de sortie (Vₛ) étant fonction de ladite valeur analogique, caractérisé en ce que le circuit de lecture de tension de sortie comprend :
une pluralité de circuit de division de tension (R₃, R₅; R₄, R₆) recevant ladite tension de sortie (Vₛ) à titre de tension d'entrée (Vₛ) audit circuit de lecture de tension de capteur et ayant des valeurs de division de tension ({R₅/(R₃ + R₅)}, ({R₆/(R₄ + R₆)}) différentes, afin de fournir une pluralité de tensions de division (${\text{V}}_{\text{AD1}} {\text{= {R}}_{\text{5}} {\text{/(R}}_{\text{3}} {\text{+ R}}_{\text{5}} \text{)}Vs}$; ${\text{V}}_{\text{AD2}} {\text{= {R}}_{\text{6}} {\text{/(R}}_{\text{4}} {\text{+ R}}_{\text{6}} {\text{)}V}}_{\text{S}}$), chaque circuit de division de tension (R₃, R₄; R₄, R₆) divisant ladite tension (Vₛ) selon la valeur de division de tension ({R₅/(R₃ + R₅)}; ({R₆/(R₄ + R₆)}) respective, afin de fournir une tension de division respective (${\text{V}}_{\text{AD1}} {\text{= {R}}_{\text{5}} {\text{/(R}}_{\text{3}} {\text{+ R}}_{\text{5}} {\text{)}V}}_{\text{s}}$; ${\text{V}}_{\text{AD2}} {\text{= ({R}}_{\text{6}} {\text{/(R}}_{\text{4}} {\text{+ R}}_{\text{6}} {\text{)}V}}_{\text{S}} \text{)}$;
un circuit de conversion analogique-numérique (15) pour convertir la pluralité des tensions de division en des valeurs numériques; et
des moyens de discrimination (16) pour effectuer la discrimination entre les tensions de division (VAD₁, VAD₂) introduites audit circuit de conversion analogique/numérique (15), individuellement, à l'aide de bornes d'entrée (AD1, AD2) dudit circuit de conversion analogique-numérique (15), à titre de tension de sortie (Vₛ) dudit capteur (12).

2. Un circuit de lecture de tension de capteur selon la revendication 1, caractérisé en ce que lesdits moyens de discrimination (16) sont constitués par un circuit de suppression de tension de bruit, devant supprimer les bruits électriques de valeur égale (Vₙ), introduits individuellement depuis les bornes d'entrée (AD1, AD2) dudit circuit de conversion analogique/numérique (15), à partir des valeurs numériques respectives obtenues par conversion dudit circuit de conversion analogique-numérique (15).

3. Un circuit de lecture de tension de capteur selon la revendication 2, caractérisé en ce que le circuit de suppression de la tension de bruit est adapté pour calculer la différence entre une première tension de division (V_{AD1}) et une deuxième tension de division (V_{AD2}) et pour calculer la tension de sortie (Vₛ) à partir de cette différence.

4. Un circuit de lecture de tension de sortie selon l'une des revendications précédentes, caractérisé par
des moyens de commutation de tension (Tr₁, Tr₂) pour fournir ou couper une tension d'alimentation devant être fournie à une borne de source de puissance (1) dudit capteur (12); et
des moyens de commande (16) pour alimenter des moyens de commutation de tension (Tr₁, Tr₂) pour fournir la tension d'alimentation à la borne de source de puissance (1) dudit capteur (12) et alimenter lesdits moyens de lecture de sortie de capteur (15) afin de lire la tension de sortie (Vs₁) dudit capteur (12);
dans lequel la tension d'alimentation est fournie à la borne de source de puissance (1) du capteur (12), uniquement lorsque la tension de sortie (V_{S1}) du capteur (12) doit être lue.
